# EUROPEAN PATENT APPLICATION

(11) **EP 0 872 897 A2**
(43) Date of publication of application: **21.10.1998**
(21) Application number: 98302823.4
(22) Date of filing: 09.04.1998
(51) Int. Cl.: H01L 31/112, H01L 27/148

(54) **Photodetectors using charge transfer**

(30) Priority: 11.04.1997 GB 9707379
(71) Applicant: EEV LIMITED, Chelmsford, Essex, CM1 2QU (GB)
(72) Inventor: Pool, Peter James, Maldon, Essex CM9 2BJ (GB)
(74) Representative: Cockayne, Gillian

(57) **Abstract**

A photodetector arrangement includes a detector area 1 at which charge is developed which is representative of incident radiation to which the detector area is sensitive. The detector area is substantially square and includes a plurality of transfer electrodes 2 arranged in a diagonal direction across the detector area 1. Clock pulses are applied at 5 to transfer charge across the detector area 1 in the direction shown by the arrow to a single output 3 from which it is applied to a voltage sensing diode 4. The photodetector arrangement may be designed to have a large detector area with a small capacitance and is particularly suitable for detecting single X-ray photons. Supplementary channels or notches may be included in the detector area substrate to improve charge transfer efficiency across the device.

## Description

This invention relates to photodetectors and more particularly but not exclusively, to photodetectors suitable for detecting single photon events.

A known means for detecting photons involves the use of a photodiode, such as a PIN photodiode. When the photodiode is subjected to incident radiation of a frequency to which it is responsive it generates a charge. A voltage is developed across the photodiode which is dependent on the energy of the radiation. The voltage is given by V=Q/C where Q is the photogenerated charge and C is the parallel capacitance associated with the diode and its connections. The voltage is monitored to determine the amount of photogenerated charge which is produced.

The magnitude of the voltage across the photodiode for a particular charge is governed by capacitance. In many applications, a photodiode or array of photodiodes will give acceptable performance. However, for some uses, it is necessary to have a small capacitance to achieve an adequate charge to voltage conversion factor for the detector. This is a particular problem where photodiodes are used to sense single X-ray photons, for example, particularly if the density of the photon events is small so that the diode area must be increased, hence increasing capacitance, to achieve a useful count rate. For such applications, typically, a PIN diode is incorporated into a special low capacitance package which is expensive to fabricate.

Another device used to detect radiation is the charge coupled device (CCD) which typically comprises a plurality of pixels arranged in an array of rows and columns. In a frame transfer type CCD, photogenerated charge is accumulated during an integration period in the pixels which are defined by electrodes controlling the potential profile in the semiconductor substrate. Following integration, photocharge representative of the incident radiation is transferred in columns by a parallel register using appropriate clock signals to control the potential profile and move the signal charge through the device. The outputs of the parallel register are applied to a serial register and the charge clocked from the serial register row by row to a small on-chip diode which is directly connected to the gate of a transistor connected as a source follower. Other CCD configurations are also possible, such as the inter-line transfer type in which charge is transferred from each column of an image section to an adjacent store section and from the store sections to a serial output register. CCD's are widely used in imaging applications giving good spatial resolution but are complex devices compared with the photodiode and significantly more expensive to manufacture.

The present invention seeks to provide a photodetector which is relatively simple to implement and which has a good charge to voltage conversion factor.

According to the invention, there is provided a photodetector arrangement comprising: a radiation sensitive detector area at which charge is generated which is representative of incident radiation to which the area is sensitive; a plurality of electrodes defining a non-uniform array of pixels for transferring charge across the area; a single output to which charge is transferred from the area; and a charge-to-voltage convertor to which charge is applied from the output.

In using the invention, charge accumulated over an area, which may be relatively large, is transferred from the area in a linear fashion to the single output. As the conversion from charge to voltage occurs at a region remote from the detector area, the area may be made as large as desired without increasing the capacitance at the voltage detector. The structure of a photodetector arrangement in accordance with the invention is much simpler than a normal CCD structure as it does not require serial and parallel registers to transfer charge from the detector area. It is hence much simpler to operate and thus a system incorporating it is cheaper to produce. Charge is transferred across the area to the single output using the electrodes to control the potential profile in the detector area in the same way that pixels are defined by transfer electrodes in a typical CCD. The charge-to-voltage converter may also be as used in a conventional CCD.

The pixels are defined by the electrodes. In a CCD, the pixels are of uniform size and arranged in a regular array. In a photodetector in accordance with the present invention, the pixels are in a non-uniform array so that they are able to direct charge from an area to a single output on application of appropriate clock signals to the electrodes. The pixels may be non-uniform in that they are of different dimensions, for example, the pixels may all be rectangular and have the same width but be of differing lengths and/or they may be spatially distributed in a non-uniform fashion. Some of the array may be regular but the array is not uniform over its entire extent.

A photodetector arrangement in accordance with the invention is particularly suitable for applications, such as X-ray spectroscopy, where single X-ray events occur at a low rate.

However, the photodetector arrangement may be used in other applications also where spatial resolution is not a requirement. The photodetector may be used to detect radiation over a wide range of wavelengths depending on its structure in the same way that CCDs can be used to detect optical radiation in the visible, infra-red or UV parts of the spectrum, or high energy radiation such as X-rays or high energy electrons.

Although it is preferred that the charge is transferred from the detector area to the charge to voltage convertor directly, in some applications an intervening stage such as a serial register may be included. However, although the benefits of de-coupling the conversion part of the arrangement from the detector area are still obtained, the structure becomes more complex and more complicated to operate.

In one particularly advantageous embodiment of the invention, the detector area is rectangular or square in configuration and the pixels defined by the transfer electrodes are elongate regions arranged parallel to one another and diagonally across the detector area. The single output in this case is located most appropriately in a corner of the detector area. Charge is transferred across the detector area in a substantially diagonal direction orthogonal to the direction of the electrodes and pixels. The shape of the detector area in combination with the non-uniform array of pixels "sweeps" any charge generated at the detector area to the output. Use of the detector area configuration in combination with the arrangement of electrodes, provides a particularly simple electrode structure compared to a typical imaging CCD structure.

The detector area may be provided in one example of the invention with two outputs in opposite corners of a rectangular or square shaped detector area. At any time, the charge developed in the detector area may be swept in one direction only to one single output by applying suitable clocking pulses to the electrodes. Following this, the direction of charge transfer may be reversed to be directed towards the second single output. At any time, therefore, the charge developed in the area will be transferred to a single output only depending on the direction of transfer chosen. In another mode of operating such architecture, charge from one half of the detector array may be transferred to one output and charge from the other half of the detector array to the other output, in effect the photodetector arrangement acting as two adjoining detectors each with its own single output for receiving charge from its area. The provision of two outputs may also make the photodetector arrangement more versatile when incorporating it into other equipment or into an array as either one of the two outputs may be used depending on the requirements.

Another embodiment of the invention includes a detector area which has three adjoining straight orthogonal sides with a fourth side extended outwardly to define a funnel. In this arrangement, some pixels of the non-uniform pixel array may be of the same dimensions and regularly spaced apart but those in the funnel nearer the single output will gradually diminish in length to cause charge to be swept towards the output. In other embodiments, curved pixels and electrodes may be used to give a focussing effect to direct charge towards the output. Supplementary channels are suitable for use where the detector area comprises a buried channel over its area. In an alternative embodiment, the supplementary channel may be replaced by a patterned buried channel separated by narrow strips of surface channel, charge tending to move to the buried channel regions.

The detector area configuration need not be confined to rectilinear geometries or regular shapes. Any configuration which in combination with the pixel array allows charge to be directed from the detector area to the output may be suitable, for example, the detector area may be substantially circular.

In one particularly advantageous embodiment of the invention, supplementary channel means is included in the detector area. The use of a supplementary channel, also termed a notch, is known in CCD technology. Its purpose is to confine small charge packets to narrow transfer channels to give good charge transfer efficiency. It is known that charge transfer efficiency is low when the charge is allowed to occupy a large volume of silicon. A photodetector arrangement in accordance with the invention accordingly may also benefit from a similar structures configured to minimize the distance over which charge is transferred before falling into a narrow transfer channel structure. The supplementary channels are formed by, for example, using ion implantation to modify the potential profile at the semiconductor detector area such that charge generated or held in a particular pixel tends to occupy a smaller volume of that pixel. Advantageously in one embodiment, at least one supplementary channel is included arranged substantially orthogonal to the directions of the electrodes. Where the transfer electrodes and pixels are extensive diagonally across a rectangular detector area, say, one supplementary channel may be aligned with the other diagonal and be arranged to reach the output. Supplementary channels are suitable for use where the detector area comprises a buried channel over its area. In an alternative embodiment, the supplementary channel may be replaced by a patterned buried channel separated by narrow strips of surface channel, charge tending to move to the buried channel regions.

The single output may be in the form of a small extension to a large detector area, for example, located in the corner of a rectilinear detector area. However, such an extension region is not essential.

In many applications for which the invention is suitable data obtained will be sparse and, it is not necessary to reset the voltage on the sensing diode after each pixel transfer. In a preferred embodiment of the invention, reset means are included for detecting when a pre-set level of voltage has been developed at the charge to voltage converter and then resetting the convertor. With such an arrangement, the CCD may be clocked continuously and the output sampled at the charge to voltage convertor for each pixel clocked to the output. The reset pulse may be applied "on demand" when the pre-set level is reached. This mode of operation is simple to implement and generates only a small "dead time" when the diode is reset. When a photon event to be detected occurs, this will be detected by a significantly large voltage being produced.

A further advantage of this feature is that if charge from a detected photon event is split between two transfer channels or pixels, because the photon is absorbed at a boundary or because of transfer inefficiency, it may be re-combined at the output.

A photodetector arrangement in accordance with the invention may be implemented with only a single detector area. However, it may be desired for some applications to use a plurality of arrangements in an array.

Some ways in which the invention may be performed are now described with reference to the accompanying drawings in which:
Figure 1 schematically illustrates a photodetector arrangement in accordance with the invention giving a schematic plan view;
Figure 2 is an explanatory diagram relating to the operation of the photodetector arrangement of Figure 1;
Figure 3 schematically illustrates a supplementary channel structure underlying the electrodes for the arrangement shown in Figure 1; and
Figures 4, 5 and 6 schematically illustrate in plan view respective different photodetector arrangements in accordance with the invention.

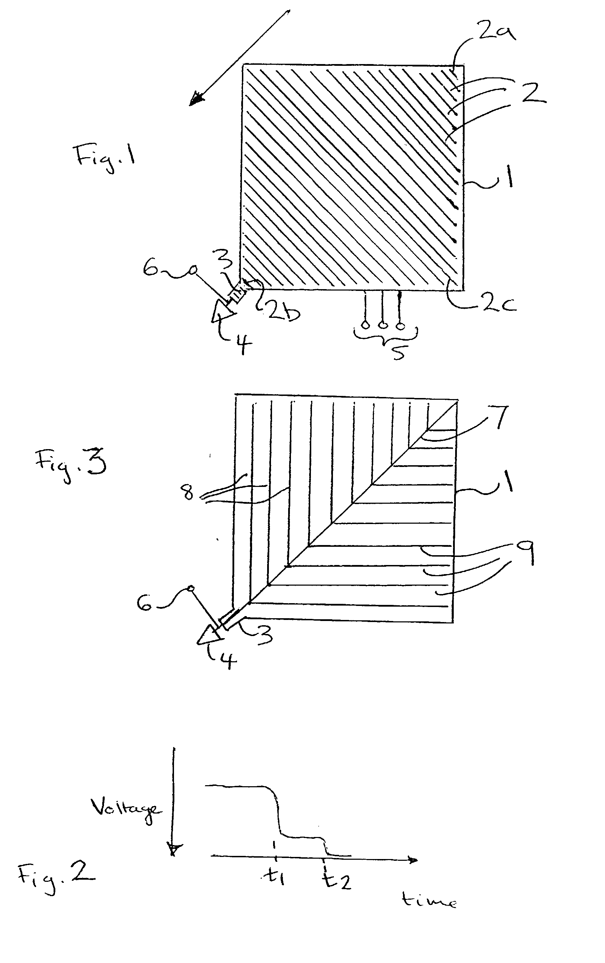

With reference to Figure 1, a photodetector arrangement in accordance with the invention used to detect X-ray photons includes a substantially square detector area 1 of semiconductor material which, when subjected to incident radiation of a suitable wavelength, causes signal charge to be developed which is representative of the incident radiation. A plurality of transfer electrodes 2 are distributed across the surface of the detector area 1. In this embodiment, the transfer electrodes are arranged parallel to one another in a diagonal direction across the detector area 1, those electrodes 2a and 2b at the corners of the area being shorter than the transfer electrode 2c across the long diagonal. Thus the pixel array is non-uniform as adjacent pixels are of different lengths. The detector area 1 is extended at one corner to define an output 3 and is connected to a charge sensing diode 4. The transfer electrodes 2 are connected to terminals 5 at which clock pulses are applied during operation of the device to control the movement of charge across the detector area. These are operated in the same way as a conventional three-phase CCD device with the potentials on the transfer electrodes 2 being varied in sequence so as to cause charge generated at one part of the detector array to be moved to the output 3 by varying the potential profile in the detector area. Other clocking schemes may be implemented based on those available for conventional imaging CCD devices. A reset terminal 6 allows a reset pulse to be applied to the charge sensing diode 4 when the diode voltage has risen to a pre-set level.

During operation of the photodetector arrangement, clock pulses are applied at 5 to the transfer electrodes 2 to continuously cause any charge generated in the detector area 1 to be transferred across the device, in the direction shown by the arrow, orthogonal to the direction in which the electrodes are extensive. The charge is channelled by the transfer electrodes 2 and by the boundaries of the detector area 1 towards the output 3 of the detector area 1, which constitutes a single output of the photodetector arrangement. The charge is applied from the output 3 to the voltage sensing diode 4 which has a very low capacitance associated with it of only a few femtoFarads, the detector area and sensing capacitance being independent of one another. As each packet of charge is clocked from the output 3 to the sensing diode 4, the diode voltage rises until it reaches the pre-set level. When this voltage is reached, a reset pulse is applied at 6 to reset the diode voltage. When an X-ray photon is incident on the detector area, a large amount of charge is generated within the detector area in a pixel defined by the electrodes 2. This charge is significantly larger than that clocked out when there is no incident radiation present and is detectible at the sensing diode 4 as a large voltage. Photons of different energies may be discriminated by the amount of charge which they generate on absorption, and hence the magnitude of the voltage detected.

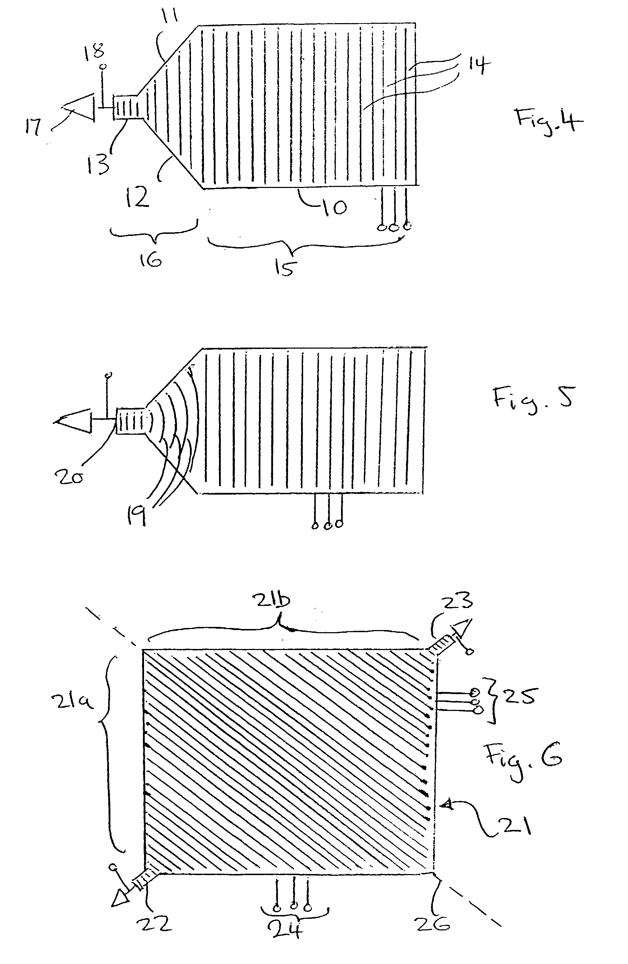

By employing reset "on demand" it is possible to re-combine charge from a detected photon event which has been split between two pixels. This is illustrated in Figure 2 which shows voltage at the sensing diode 4 against time. As charge from the detector area is continuously clocked out and applied to the diode 4 there is only a small change in voltage until the first part of the charge generated by the incident photon is applied at time tl. The second part of the charge is applied when the next clock sequence occurs to cause a voltage change at time t2. The diode 4 thus effectively shows the total voltage change for the charge spread between the two pixels with only one read noise contribution, no reset pulse being applied between the two parts of the charge being applied to the diode 4.

The continuous clocking of the device described above is suitable for applications where data will be sparse with very few photon events expected. However, in other applications it may be necessary to reset the diode voltage for each new packet of charge clocked from the single output 3.

The arrangement as described above in respect of Figure 1 may operate satisfactorily. However, as some of the pixels defined by the transfer electrodes 2 are of significant length, charge may tend to occupy a large volume of silicon at the detector area 1, reducing charge transfer efficiency. Discrimination of photon energies will be degraded if the charge is spread over more than one pixel by poor charge transfer efficiency. Thus, in this embodiment, supplementary channels are also included in the detector area as shown in Figure 3. The supplementary channels are arranged in a configuration having a central channel 7 across the diagonal which is orthogonal to the direction in which the transfer electrodes 2, shown in Figure 1, extend. This central supplementary channel extends into the extended output portion 3 of the detector area 1. Additional supplementary channels join the central channel 7. One set of additional supplementary channels 8 occupies one half of the detector area and the other set 9, arranged orthogonal to the first set 8, is in the other part of the detector area. The supplementary channels may be fabricated by ion implantation or other techniques to give the required potential profile. Charge located in the volume defined by this profile tends to accumulate at the central portion and be kept confined rather than being allowed to occupy a larger volume of the silicon in which the charge is generated. The arrangement shown minimizes the distance over which charge generated at the detector area 1 is transferred before falling into a narrow supplementary channel structure.

Figure 4 illustrates another embodiment of the invention in which the detector area 10 has three sides orthogonal to one another and two converging sides 11 and 12 to define a funnel towards the single output 13. The sloping sides 11 and 12 may be straight as shown or may be curved. The pixels defined by the transfer electrodes 14 are uniformly arranged in part of the detector area 15 and then diminish in length at the funnel 16 region to sweep charge developed in the detector area towards the single output 13. Again, the output 13 is connected to a sensing diode 17 and a terminal 18 is provided to apply a reset pulse to the diode 17.

Figure 5 illustrates another embodiment of the invention in which some of the transfer electrodes 19 are curved to define curved pixels and give further direction to charge transferred from the detector area to the single output 20.

With reference to Figure 6, in another embodiment of the invention, the detection area 21 is substantially rectangular but in this case has two extensions 22 and 23 in opposite corners defining respective different single outputs. The electrodes structure is similar to that shown in Figure 1 but in this case two sets of clock terminals 24 and 25 are provided. In effect, the photodetector arrangement operates as two detectors with charge from the left side of the area 21a as shown a being clocked to the output 22 and that to the right of the diagonal 26 at area 21b being clocked to the second single output 23. This device may be operated in other modes. For example, the clock pulses applied to terminals 24 and 25 may be controlled to transfer charge from the whole of the detector area 21 in one direction only to a selected single output such that the device operates as that shown in Figure 1. In an alternative mode, charge may be clocked to one output 22 at one time and then to the second single output 23 at another time.

## Claims

1. A photodetector arrangement comprising: a radiation sensitive detector area (1, 10, 21) at which charge is generated which is representative of incident radiation to which the area is sensitive; a plurality of transfer electrodes (2, 14, 19) defining a non-uniform array of pixels for transferring charge across the area (1, 10, 21); a single output (3, 13, 20, 22, 23) to which charge is transferred from the area; and a charge-to-voltage converter (4, 17) to which charge is applied from the output (3, 13, 20, 22, 23).

2. An arrangement as claimed in claim 1 and including supplementary channel means (7, 8, 9) in the detector area (1).

3. An arrangement as claimed in claim 2 and wherein the supplementary channel means includes a supplementary channel (7) extending substantially orthogonal to the direction in which the transfer electrodes (2) extend.

4. An arrangement as claimed in claim 3 wherein the supplementary channel (7) extending substantially orthogonal to the transfer electrode direction is connected to the output (3).

5. An arrangement as claimed in claim 2, 3 or 4 wherein the supplementary channel means includes a first and a second set (8) of supplementary channels which is extensive in a direction substantially orthogonal to the second set (9) of supplementary channels.

6. An arrangement as claimed in any preceding claim wherein the detector area (1, 21) is substantially rectangular or square in configuration and with the electrodes are extensive being arranged diagonally across said detector area (1, 21).

7. An arrangement as claimed in claim 6 wherein the output (3, 22, 23) is located at a corner of the detector area (1, 21).

8. An arrangement as claimed in any preceding claim wherein the detector area (10) includes a portion (12) of decreasing width at which the output (13, 20) is located.

9. An arrangement as claimed in any preceding claim wherein the transfer electrodes (2, 14) are substantially straight.

10. An arrangement as claimed in claims 1 to 8 in which some (19) at least the transfer electrodes are curved.

11. An arrangement as claimed in any preceding claim and including means (6, 18) for resetting the charge-to-voltage convertor when a pre-set voltage is detected at its output.

12. An arrangement as claimed in any preceding claim adapted to detect high energy radiation.

13. An arrangement as claimed in claim 1 and including a second single output (23) which charge is transferrable from the detector area (21).

14. An arrangement as claimed in claim 13 and wherein the detector area (21) is substantially rectangular or square and said first mentioned single output (22) is located opposite the second single output (23).

15. An arrangement as claimed in claim 14 wherein the first mentioned single output (22) is located at a first corner of the detector area (21) and the second single output (23) is located at a second corner diagonally opposite the first corner.

16. A method for detecting incident radiation including the steps of:
taking a radiation sensitive detector having a detector area (1, 10, 21) at which charge is generated which is representative of incident radiation to which the area is sensitive and the detector including a plurality of transfer electrodes (2, 14, 19) defining a non-uniform array of pixels for transferring charge across the area (1, 10, 21);
controlling potentials applied to the transfer electrodes (2, 14, 19) to transfer charge generated at the detector area to a single output (3, 13, 20, 22, 23) from the whole area;
applying charge from the output to a charge-to-voltage converter (4, 17).

17. A method as claimed in claim 16 and including the steps of at one time transferring charge from the whole of the detector area (21) to a first mentioned single output (22) and subsequently transferring charge from the whole of the detector area (21) to another single output (23).

18. A method as claimed in claim 16 or 17 and including the step of re-setting the charge-to-voltage converter (4, 17) when a pre-set voltage is detected at its output.
